(19) **Europäisches Patentamt / European Patent Office / Office européen des brevets**

(11) **EP 4 352 525 B1**

(12) **FASCICULE DE BREVET EUROPEEN**

(45) Date de publication et mention
de la délivrance du brevet:
**09.04.2025 Bulletin 2025/15**

(21) Numéro de dépôt: **22735504.7**

(22) Date de dépôt: **21.04.2022**

(51) Classification Internationale des Brevets (IPC):
**G01R 31/382** (2019.01)    **G01R 31/389** (2019.01)
**G01R 31/392** (2019.01)

(52) Classification Coopérative des Brevets (CPC):
**G01R 31/392; G01R 31/382; G01R 31/389**

(86) Numéro de dépôt international:
**PCT/FR2022/050753**

(87) Numéro de publication internationale:
**WO 2022/258895 (15.12.2022 Gazette 2022/50)**

(54) **PROCEDE D'ESTIMATION DE L'ETAT DE SANTE RESISTIF D'AU MOINS UN ELEMENT DE STOCKAGE D'ENERGIE ELECTRIQUE D'UNE BATTERIE ELECTRIQUE**

VERFAHREN ZUR SCHÄTZUNG DES RESISTIVEN GESUNDHEITSZUSTANDS VON MINDESTENS EINEM ELEKTRISCHEN ENERGIESPEICHERELEMENT EINER ELEKTRISCHEN BATTERIE

METHOD FOR ESTIMATING THE RESISTIVE STATE OF HEALTH OF AT LEAST ONE ELECTRICAL ENERGY STORAGE ELEMENT OF AN ELECTRIC BATTERY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **10.06.2021 FR 2106129**

(43) Date de publication de la demande:
**17.04.2024 Bulletin 2024/16**

(73) Titulaire: **Stellantis Auto SAS
78300 Poissy (FR)**

(72) Inventeurs:
• **EDDAHECH, Akram
78280 GUYANCOURT (FR)**
• **MAWONOU, Kodjo Senou Rodolphe
78990 ELANCOURT (FR)**

(74) Mandataire: **PSIP
Stellantis
Service REIP
Propriété industrielle - YT800
2-10, boulevard de l'Europe
78300 Poissy (FR)**

(56) Documents cités:
**EP-A1- 3 002 597        EP-A1- 3 605 127
CN-B- 109 725 266      FR-A1- 2 965 361
FR-A1- 2 968 769        US-A1- 2016 327 613**

• **REMMLINGER JÜRGEN ET AL: "On-board state-of-health monitoring of lithium-ion batteries using linear parameter-varying models", JOURNAL OF POWER SOURCES, ELSEVIER, AMSTERDAM, NL, vol. 239, 30 November 2012 (2012-11-30), pages 689 - 695, XP028566892, ISSN: 0378-7753, DOI: 10.1016/ J.JPOWSOUR.2012.11.102**

**Description**

La présente invention revendique la priorité de la demande française N°2106129 déposée le 10.06.2021.

L'invention se rapporte à un procédé, mis en œuvre dans un système de gestion d'une batterie électrique d'un véhicule, d'estimation de l'état de santé résistif d'au moins un élément de stockage d'énergie électrique de ladite batterie électrique. Sans que cela ne soit limitatif dans le cadre de la présente invention, l'élément de stockage d'énergie électrique peut être par exemple une cellule de stockage d'énergie électrique, un module de stockage d'énergie électrique constitué de plusieurs cellules de stockage reliées en série, ou encore une batterie électrique constituée de plusieurs modules de stockage reliés en série. La batterie électrique est typiquement mais non limitativement une batterie de traction du véhicule, notamment une batterie lithium-ion.

Il est nécessaire de prévoir, dans un véhicule électrique ou hybride à batterie de stockage électrique, un système de gestion des fonctions de la batterie (appelé BMS en anglais pour « Battery Management System »). Un tel système permet d'assurer la supervision de l'état de santé de la batterie et de sa sécurité afin de permettre une exploitation optimale de la batterie sans défaillance ou risque pour l'utilisateur. Le diagnostic de la batterie effectué par un tel système constitue ainsi un élément important permettant d'optimiser l'usage de la batterie au plus juste, de réduire les coûts de réparation et de prévenir prématurément tout disfonctionnement majeur.

Or, la dégradation de la résistance interne de la batterie (appelée DCR en anglais pour « Direct Current Resistance ») conditionne les niveaux de puissance que cette dernière est à même de fournir. Dans ce contexte, il existe un besoin de pouvoir disposer d'une estimation précise de la résistance interne de la batterie, afin d'éviter une surestimation des limitations de la puissance que la batterie sera à même de fournir à un état vieilli.

A cet effet, une première solution connue consiste à réaliser un diagnostic de la batterie sur un banc de test dédié, en extrayant au préalable la batterie du véhicule dans lequel elle est normalement installée puis en lui appliquant des impulsions de courant afin de déterminer la résistance interne de la batterie. Toutefois, un inconvénient d'un tel procédé de diagnostic sur banc de test est qu'il nécessite d'utiliser des moyens spécifiques (banc de test dédié) qui sont relativement coûteux. En outre, un tel procédé ne peut pas être mis en œuvre pendant une phase d'utilisation normale du véhicule, telle qu'une phase de roulage, et nécessite d'immobiliser le véhicule pour procéder au diagnostic, ce qui est contraignant.

Une deuxième solution connue consiste à reconstituer la valeur de la résistance interne de la batterie à partir d'une approche modèle. Le document brevet EP 3 605 127 A1 décrit par exemple un procédé et un dispositif pour mettre en œuvre le procédé, dans lequel la résistance interne de la batterie est estimée par un algorithme utilisant une approche paramétrique, notamment par interpolation ou extrapolation. Toutefois, une telle estimation paramétrique de la résistance interne nécessite de recourir à des algorithmes complexes et difficiles à embarquer en temps réel au sein du système de gestion de la batterie électrique installé dans le véhicule.

Les documents FR 2 965 361 A1 et FR 2 968 769 A1 divulguent un procédé d'estimation de l'état de santé d'une batterie d'un véhicule.

Le but de l'invention est de pallier les inconvénients de l'art antérieur en proposant un procédé, mis en œuvre dans un système de gestion d'une batterie électrique d'un véhicule, d'estimation de l'état de santé résistif d'au moins un élément de stockage d'énergie électrique de la batterie électrique, qui soit simple, robuste et réactif et qui puisse être mis en œuvre pendant des phases de roulage du véhicule tout en permettant d'estimer précisément les limitations de la puissance que la batterie est à même de fournir à un état vieilli. Le fait d'estimer l'état de santé résistif (appelé SOHR en anglais pour « State Of Health Resistance ») d'au moins un élément de stockage d'énergie électrique de la batterie électrique est plus précis que d'estimer uniquement la résistance interne. La résistance interne de la batterie dépend en effet du courant, de l'état de charge (appelé SOC en anglais pour « State Of Charge »), de la température et du vieillissement avec un comportement parfois hautement non linéaire à bas état de charge, basses températures et très hautes valeurs de courant.

Pour ce faire, l'invention se rapporte ainsi, dans son acceptation la plus large, à un procédé, mis en œuvre dans un système de gestion d'une batterie électrique d'un véhicule, d'estimation de l'état de santé résistif d'au moins un élément de stockage d'énergie électrique de ladite batterie électrique, le procédé comportant les étapes suivantes :

- une détermination d'au moins une plage de fonctionnement pour laquelle la résistance interne dudit au moins un élément de stockage d'énergie électrique évolue de manière linéaire vis-à-vis d'un couple de variables constitué de l'état de charge de l'élément de stockage et de la température ;
- une mesure, pour plusieurs points de fonctionnement de ladite au moins une plage de fonctionnement déterminée et pendant une durée prédéfinie, de la variation de l'intensité et de la tension d'un courant électrique généré par ledit au moins un élément de stockage d'énergie électrique pendant au moins une phase de roulage du véhicule ;
- un calcul, en fonction des valeurs de variation d'intensité et de tension mesurées et pour chacun desdits points de fonctionnement, d'au moins une valeur de résistance interne dudit au moins un élément de stockage d'énergie électrique ; et

- un calcul, pour chacun desdits points de fonctionnement, en fonction de la valeur de résistance interne calculée pour ledit point de fonctionnement, d'au moins une valeur d'état de santé résistif dudit au moins un élément de stockage d'énergie électrique.

En exploitant des mesures effectuées pendant des moments opportuns de roulage du véhicule et pour des plages de fonctionnement bien choisies, le procédé selon l'invention permet d'obtenir une estimation précise de l'état de santé résistif de l'élément de stockage d'énergie électrique. Ceci permet d'éviter une surestimation des limitations de la puissance que la batterie est à même de fournir à un état vieilli et permet de limiter par conséquence l'accélération du vieillissement de la batterie. Ceci permet également d'éviter des éventuels problèmes de sous-tension ou de surtension (risque de récurrences accrues d'un mode dysfonctionnel si l'estimation de l'état de santé résistif et donc de la puissance n'est pas correcte). Le procédé selon l'invention contribue ainsi notamment à la seconde vie de la batterie électrique, en permettant d'identifier le degré de dégradation de sa résistance interne. Ceci permet par exemple de trier les batteries en seconde vie en fonction de leur valeur d'état de santé résistif déterminée via le procédé. Par ailleurs, les calculs effectués par le procédé selon l'invention sont des calculs relativement simples, qui sont effectués en temps réel et ne nécessitent pas de recourir à des méthodes complexes d'identification. Le procédé selon l'invention est en outre robuste et également réactif car il permet de détecter des défauts d'augmentation accrue de résistance interne de l'élément de stockage d'énergie électrique. Enfin, du fait que le procédé selon l'invention est mis en œuvre dans un système de gestion de la batterie électrique du véhicule pendant des phases de roulage de ce dernier, il n'impose pas de devoir sortir la batterie de son cadre d'usage pour déterminer son état de santé résistif, contrairement à certains procédés de l'art antérieur.

De préférence, l'étape de mesure de la variation de l'intensité et de la tension d'un courant électrique est effectuée pendant un cycle dynamique de conduite du véhicule.

Avantageusement, lors de l'étape de détermination d'au moins une plage de fonctionnement pour laquelle la résistance interne dudit au moins un élément de stockage d'énergie électrique évolue de manière linéaire, ladite au moins une plage de fonctionnement déterminée est une plage de fonctionnement pour laquelle la résistance interne dudit au moins un élément de stockage d'énergie électrique évolue de manière linéaire vis-à-vis de l'état de charge de l'élément de stockage, de la température et de l'intensité du courant électrique. Ceci permet de mieux maîtriser le comportement de la résistance interne de l'élément de stockage d'énergie électrique, et d'améliorer ainsi la précision du procédé.

De préférence, le procédé comporte en outre une étape de vérification, pour chacun desdits points de fonctionnement, d'au moins une condition remplie par l'intensité et/ou la tension du courant électrique généré par ledit au moins un élément de stockage d'énergie électrique, ladite étape de vérification étant effectuée entre l'étape de détermination et l'étape de mesure, la mesure de la variation de l'intensité et de la tension du courant électrique généré étant effectuée si ladite au moins une condition est vérifiée.

Selon une caractéristique technique particulière de l'invention, une première condition à vérifier consiste en ce que la valeur de l'intensité du courant électrique généré soit inférieure à une valeur seuil proche de zéro sur une première période prédéfinie, et une deuxième condition à vérifier consiste en ce que l'intensité et la tension du courant électrique généré présentent chacune une valeur constante ou quasi constante sur une seconde période prédéfinie.

Selon une autre caractéristique technique particulière de l'invention, une troisième condition à vérifier consiste en ce que, à l'issue de la seconde période prédéfinie, la valeur de l'intensité du courant électrique généré soit inférieure à une valeur seuil d'intensité maximale, et/ou la variation de l'intensité du courant électrique entre le début et la fin de la seconde période prédéfinie soit supérieure à une valeur de variation seuil. La vérification de la première sous-condition de cette troisième condition permet de respecter la non-linéarité due au courant élevé sur la résistance interne de l'élément de stockage d'énergie électrique. La vérification de la seconde sous-condition de cette troisième condition permet d'obtenir un rapport signal sur bruit suffisamment significatif pour ne pas nuire à la précision de l'estimation.

Avantageusement, l'étape de mesure est effectuée pour plusieurs phases de roulage du véhicule, et l'étape de calcul d'au moins une valeur d'état de santé résistif comporte une première phase de calcul, pour chacun desdits points de fonctionnement, de plusieurs valeurs d'état de santé résistif intermédiaires, chaque valeur d'état de santé résistif intermédiaire étant associée, pour ledit point de fonctionnement, à une phase de roulage et à la valeur de variation d'intensité mesurée pour cette phase de roulage, et une seconde phase de calcul, pour chacun desdits points de fonctionnement, en fonction desdites valeurs d'état de santé résistif intermédiaires calculées pour ledit point de fonctionnement, d'une valeur d'état de santé résistif dudit au moins un élément de stockage d'énergie électrique. Ceci permet d'effectuer un filtrage robuste des valeurs brutes d'état de santé résistif intermédiaires calculées, ce qui rend l'estimation de l'état de santé résistif de l'élément de stockage d'énergie électrique plus stable et plus précise pour le point de fonctionnement considéré. En effet, le fait de multiplier les phases de roulage pendant lesquelles les mesures sont effectuées permet de fournir un nombre minimal de valeurs d'intensité distinctes permettant de garantir un filtrage efficace et robuste. Chaque valeur d'intensité est associée à une phase de roulage distincte, et on calcule pour chaque valeur d'intensité distincte une valeur d'état de santé résistif intermédiaire pour le point de fonctionnement considéré. L'impact de l'intensité du courant électrique sur la valeur de la résistance interne de l'élément de stockage d'énergie électrique est alors pris en considération.

Selon une autre caractéristique technique particulière de l'invention, la seconde phase de calcul de l'étape de calcul d'une valeur d'état de santé résistif dudit au moins un élément de stockage d'énergie électrique consiste à appliquer une moyenne sur l'ensemble des valeurs d'état de santé résistif intermédiaires calculées lors de la première phase de calcul, et à pondérer cette moyenne en fonction des valeurs de variation d'intensité associées auxdites valeurs d'état de santé résistif intermédiaires. Cette seconde phase de calcul permet de rendre encore plus stable l'estimation de l'état de santé résistif de l'élément de stockage d'énergie électrique pour le point de fonctionnement considéré.

Selon une autre caractéristique technique particulière de l'invention, la première phase de calcul, pour chaque phase de roulage dans laquelle une mesure est effectuée, d'une valeur d'état de santé résistif intermédiaire, consiste à diviser la valeur de résistance interne calculée pour cette phase de roulage par une valeur de résistance interne prédéterminée en début de vie de la batterie électrique.

De préférence, ledit au moins un élément de stockage d'énergie électrique est choisi parmi le groupe consistant en : une cellule de stockage d'énergie électrique, un module de stockage d'énergie électrique constitué de plusieurs cellules de stockage reliées en série, et une batterie électrique constituée de plusieurs modules de stockage reliés en série. Lorsque l'élément de stockage d'énergie électrique est une cellule de stockage d'énergie électrique, cela permet par exemple de détecter des problèmes de production de cellules en usine. Lorsque l'élément de stockage d'énergie électrique est un module de stockage d'énergie électrique, on peut alors obtenir des informations quant à la dégradation de la résistance interne d'une unité remplaçable de la batterie électrique (en l'occurrence ici le module), ce qui permet de faciliter et de guider des outils de diagnostic en après-vente. En outre, un tel module constitué de plusieurs cellules de stockage reliées en série présente des caractéristiques thermiques plus homogènes (facteur qui joue sur la valeur de la résistance interne) comparativement à une cellule de stockage considérée individuellement.

On décrira ci-après, à titre d'exemples non limitatifs, des formes d'exécution de la présente invention, en référence aux figures annexées sur lesquelles :

[Fig.1] est un organigramme représentant un procédé d'estimation de l'état de santé résistif d'au moins un élément de stockage d'énergie électrique d'une batterie électrique selon la présente invention ;
[Fig.2] est un diagramme représentant l'évolution de la résistance interne de l'élément de stockage d'énergie électrique en fonction de son état de charge, pour différentes valeurs de température ;
[Fig.3] est un diagramme représentant l'évolution en fonction du temps de l'intensité et de la tension du courant électrique généré par l'élément de stockage d'énergie électrique pendant une phase de roulage du véhicule, et illustrant une étape du procédé de la figure 1 ; et
[Fig.4] est une vue schématique représentant une série de tables stockées dans une mémoire d'un système de gestion de la batterie électrique, et illustrant une étape du procédé de la figure 1.

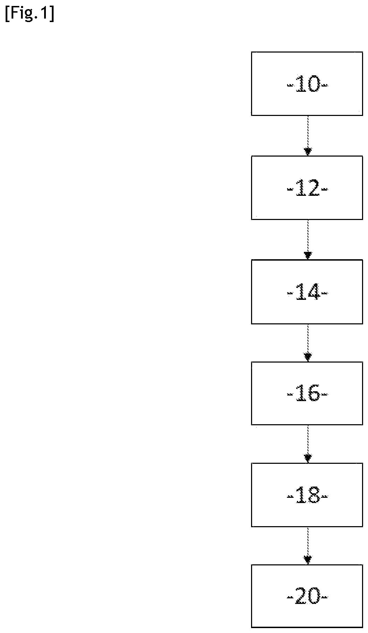

En se référant à la figure 1 la présente invention concerne un procédé, mis en œuvre dans un système de gestion d'une batterie électrique d'un véhicule, d'estimation de l'état de santé résistif d'au moins un élément de stockage d'énergie électrique de la batterie électrique. Sans que cela ne soit limitatif dans le cadre de la présente invention, l'élément de stockage d'énergie électrique peut être par exemple une cellule de stockage d'énergie électrique, un module de stockage d'énergie électrique constitué de plusieurs cellules de stockage reliées en série, ou encore la batterie électrique elle-même. La batterie électrique est typiquement mais non limitativement une batterie de traction du véhicule, notamment une batterie lithium-ion. Le véhicule est typiquement un véhicule électrique ou un véhicule hybride. Le système de gestion de la batterie électrique est muni de moyens mémoire et de moyens de traitement reliés aux moyens mémoire, de tels moyens n'étant pas représentés sur les figures pour des raisons de clarté. Le procédé est mis en œuvre au cours d'au moins une phase de roulage du véhicule.

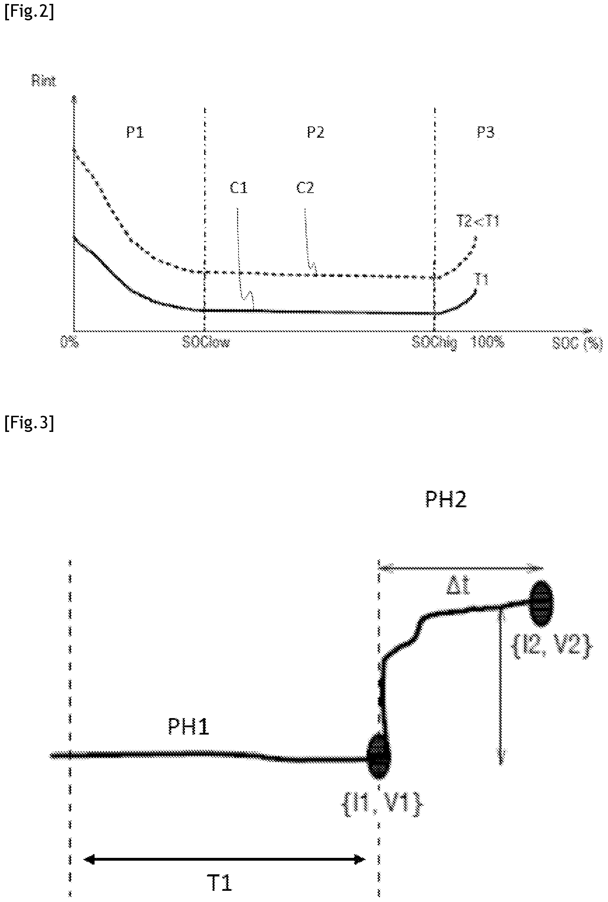

Le procédé comporte une première étape 10 au cours de laquelle le système de gestion de la batterie détermine au moins une plage de fonctionnement pour laquelle la résistance interne de l'élément de stockage d'énergie électrique évolue de manière linéaire vis-à-vis au moins d'un couple de variables constitué de l'état de charge de l'élément de stockage et de la température. Par exemple, la figure 2 illustre l'évolution de la résistance interne Rint de l'élément de stockage d'énergie électrique en fonction de son état de charge SOC (en %), pour deux valeurs de température T1, T2 (définissant ainsi deux courbes distinctes C1, C2), lorsque l'élément est une cellule de stockage d'énergie électrique. Une première température T1 est inférieure à une seconde température T2. Sur la figure 2, deux valeurs seuils particulières sont indiquées pour l'état de charge SOC : une première valeur seuil $SOC_{low}$ correspondant à un seuil de charge faible de la cellule de stockage, et une seconde valeur seuil $SOC_{hig}$ pour laquelle la cellule de stockage est chargée à 100%. De préférence, la première valeur seuil $SOC_{low}$ est choisie comme étant inférieure à la valeur d'état de charge de cellule minimale parmi l'ensemble des cellules de stockage d'énergie électrique de la batterie, et la seconde valeur seuil SO-

$C_{hig}$ est choisie comme étant supérieure à la valeur d'état de charge de cellule maximale parmi l'ensemble des cellules de stockage d'énergie électrique de la batterie.

Comme on peut le voir sur la figure 2, chacune des deux courbes C1, C2, correspondant respectivement à la première et à la seconde température T1, T2, définit trois plages de fonctionnement distinctes : une première plage de fonctionnement P1 lorsque l'état de charge SOC est inférieur à la première valeur seuil $SOC_{low}$, dans laquelle la résistance interne Rint évolue de manière quasi linéaire vis-à-vis du couple de variables constitué de l'état de charge SOC et de la température ; une deuxième plage de fonctionnement P2 lorsque l'état de charge SOC est compris entre la première valeur seuil $SOC_{low}$ et la seconde valeur seuil $SOC_{hig}$, dans laquelle la résistance interne Rint évolue de manière linéaire vis-à-vis de la température et de manière constante vis-à-vis de l'état de charge SOC ; et une troisième plage de fonctionnement P3 lorsque l'état de charge SOC est supérieur à la seconde valeur seuil $SOC_{hig}$, dans laquelle la résistance interne Rint évolue de manière linéaire vis-à-vis de la température et de manière quasi exponentielle vis-à-vis de l'état de charge SOC. Dans cet exemple de réalisation, la première plage de fonctionnement P1 peut ainsi être la plage de fonctionnement sélectionnée par le système de gestion de la batterie au cours de la première étape 10.

De préférence, lors de cette première étape 10, chaque plage de fonctionnement déterminée est une plage de fonctionnement pour laquelle la résistance interne de l'élément de stockage d'énergie électrique évolue de manière linéaire non seulement vis-à-vis du couple de variables constitué de l'état de charge de l'élément de stockage et de la température, mais également vis-à-vis de l'intensité du courant électrique généré par l'élément de stockage.

Cette première étape de détermination 10 permet au système de gestion de la batterie de s'affranchir des erreurs éventuelles de mesure de la température et d'estimation de l'état de charge de l'élément de stockage d'énergie électrique.

De préférence, le procédé comporte une étape suivante 12 au cours de laquelle le système de gestion de la batterie vérifie, pour plusieurs points de fonctionnement de chaque plage de fonctionnement déterminée au cours de l'étape 10, si au moins une condition est remplie par l'intensité et/ou la tension du courant électrique généré par l'élément de stockage d'énergie électrique. De manière avantageuse, comme illustré sur la figure 3, une première condition à vérifier consiste en ce que la valeur I1 de l'intensité du courant électrique généré soit inférieure à une valeur seuil proche de zéro sur une première période prédéfinie T1, et une deuxième condition à vérifier consiste en ce que l'intensité et la tension du courant électrique généré présentent chacune une valeur constante ou quasi constante I2, V2 sur une seconde période prédéfinie $\Delta t$. Sur le diagramme de la figure 3, la première condition est matérialisée par la phase PH1, et la deuxième condition est matérialisée par la phase suivante PH2. De préférence, le système de gestion de la batterie vérifie, pour chacun des points de fonctionnement de la plage de fonctionnement courante, si une troisième condition est vérifiée. La troisième condition consiste à vérifier que, à l'issue de la seconde période prédéfinie $\Delta t$, la valeur I2 de l'intensité du courant électrique généré est inférieure à une valeur seuil d'intensité maximale, et/ou que la variation de l'intensité du courant électrique entre le début et la fin de la seconde période prédéfinie $\Delta t$ est supérieure à une valeur de variation seuil. Cette variation de l'intensité correspond, dans l'exemple de la figure 3, à la valeur donnée par I2 - I1.

Le procédé comporte une étape suivante 14 qui est effectuée si ladite au moins une condition est vérifiée au cours de l'étape précédente 12. Si tel n'est pas le cas, le procédé réeffectue l'étape 12 pour un autre point de fonctionnement, voire reboucle à la première étape 10 si la condition n'est vérifiée pour aucun point de fonctionnement de la plage de fonctionnement courante. Au cours de cette étape suivante 14, le système de gestion de la batterie mesure, pour chacun des points de fonctionnement de la plage de fonctionnement courante et pendant une durée prédéfinie, la variation de l'intensité et de la tension du courant électrique généré par l'élément de stockage d'énergie électrique pendant la phase courante de roulage du véhicule. Dans l'exemple de la figure 3, la durée prédéfinie pendant laquelle la mesure est effectuée est la seconde durée prédéfinie $\Delta t$.

Lorsque l'élément de stockage est un module de stockage d'énergie électrique, la variation de tension mesurée est la valeur de variation de tension maximale parmi l'ensemble des cellules de stockage d'énergie électrique du module. Lorsque l'élément de stockage est la batterie électrique elle-même, la variation de tension mesurée est la valeur de variation de tension maximale parmi l'ensemble des cellules de stockage d'énergie électrique de la batterie. Ce dernier cas de figure permet avantageusement de prendre en compte des contraintes définies au niveau d'un système de diagnostic embarqué du véhicule (appelé OBD en anglais pour « On-Board Diagnostics »), telle que par exemple une perte de puissance lorsque le véhicule est un véhicule hybride de type PHEV (de l'anglais « Plug-in Hybrid Electric Vehicle »).

De préférence, cette étape de mesure 14 est effectuée pendant un cycle dynamique de conduite du véhicule. De préférence encore, cette étape de mesure 14 est effectuée pour plusieurs phases de roulage du véhicule, les étapes précédentes 10, 12 étant effectuées pour chacune de ces phases de roulage. Chaque mesure de variation de l'intensité et de la tension du courant électrique généré par l'élément de stockage d'énergie électrique est alors associée à une phase de roulage distincte. Chaque mesure, associée à une phase de roulage distincte, est également associée à une valeur d'intensité de courant électrique correspondante. De préférence, le nombre de phases de roulage pour lesquelles la mesure est effectuée au cours de l'étape 14 est supérieur ou égal à quatre.

Au cours d'une étape suivante 16, le système de gestion de la batterie calcule, en fonction des valeurs de variation d'intensité et de tension mesurées et pour chaque point de fonctionnement de la plage de fonctionnement courante, au moins une valeur de résistance interne de l'élément de stockage d'énergie électrique. Lorsque l'étape de mesure 14 est effectuée pour plusieurs phases de roulage du véhicule, le système de gestion de la batterie calcule lors de l'étape 16, pour chacun des points de fonctionnement de la plage de fonctionnement courante, plusieurs valeurs de résistance interne. Plus précisément, pour chaque point de fonctionnement de la plage de fonctionnement courante, le système de gestion de la batterie calcule autant de valeurs de résistance interne qu'il y a de phases de roulage pendant lesquelles une mesure est effectuée. Pour un point de fonctionnement donné (valeur d'état de charge, valeur de température), il y a donc plusieurs valeurs de résistance interne calculées, chaque valeur de résistance interne étant associée à une valeur d'intensité de courant électrique correspondant à une phase de roulage distincte. Pour chaque point de fonctionnement, chaque valeur de résistance interne est par exemple calculée en divisant la variation de tension mesurée lors de l'étape 14 pour la phase de roulage correspondante, par la variation d'intensité mesurée lors de cette même étape. En variante, pour chaque point de fonctionnement, chaque valeur de résistance interne peut être calculée en effectuant une interpolation ou une régression linéaire sur plusieurs points d'intensité de courant correspondant tous à une même phase de roulage donnée, et pour lesquels les mesures décrites à l'étape 14 ont été effectuées. Les différents points d'intensité de courant peuvent être espacés sur une échelle allant d'une valeur d'intensité de courant minimale correspondant à l'intensité minimale à considérer pour garantir un rapport signal sur bruit suffisamment significatif, jusqu'à une valeur d'intensité de courant maximale correspondant à l'intensité maximale à considérer pour ne pas provoquer de non-linéarité sur la valeur de résistance interne calculée. Il est possible de paramétrer un nombre minimum de nuages de points dans l'axe tension/courant à partir duquel la régression linéaire est activée. L'espacement entre les points d'intensité de courant peut être équitablement réparti en fonction du pourcentage par rapport à la valeur d'intensité de courant maximale. Un algorithme du type algorithme des moindres carrés peut être utilisé pour la régression linéaire.

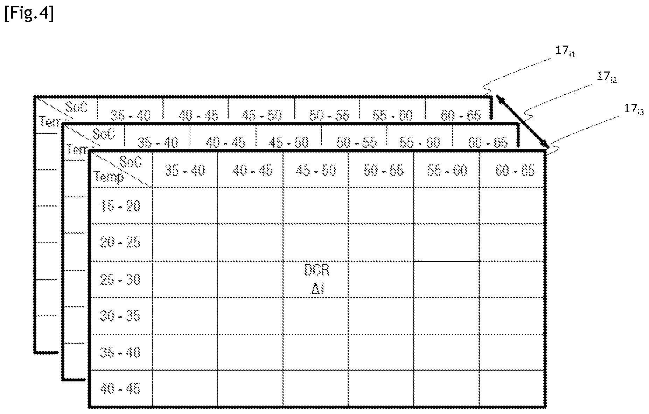

Comme illustré sur la figure 4, les différentes valeurs de résistance de résistance interne calculées DCR sont alors stockées dans des tables $17_{i1}$, $17_{i2}$, $17_{i3}$ préimplantées dans les moyens mémoire du système de gestion de la batterie. Chaque table $17_{i1}$, $17_{i2}$, $17_{i3}$ définit plusieurs points de fonctionnement (les lignes de la table définissant des valeurs de température Temp, et les colonnes des valeurs d'état de charge SoC) et correspond à une phase de roulage distincte associée à une valeur d'intensité électrique i1, i2, i3 spécifique. Chaque valeur de résistance interne calculée DCR est stockée dans une des tables $17_{i1}$, $17_{i2}$, $17_{i3}$ en lui associant la valeur de variation d'intensité correspondante $\Delta I$ mesurée lors de l'étape 14.

Au cours d'une étape suivante 18, le système de gestion de la batterie calcule, pour chacun des points de fonctionnement de la plage de fonctionnement courante, en fonction de la valeur de résistance interne calculée pour ce point de fonctionnement, au moins une valeur d'état de santé résistif de l'élément de stockage d'énergie électrique. Lorsque l'étape de mesure 14 est effectuée pour plusieurs phases de roulage du véhicule, le système de gestion de la batterie calcule, au cours d'une première phase de l'étape 18 et pour chacun des points de fonctionnement de la plage de fonctionnement courante, plusieurs valeurs d'état de santé résistif intermédiaires. Plus précisément, pour chaque point de fonctionnement de la plage de fonctionnement courante, le système de gestion de la batterie calcule autant de valeurs d'état de santé résistif intermédiaires qu'il y a de phases de roulage pendant lesquelles une mesure est effectuée. Pour un point de fonctionnement donné (valeur d'état de charge, valeur de température), il y a donc plusieurs valeurs d'état de santé résistif intermédiaires calculées, chaque valeur d'état de santé résistif intermédiaire étant associée à une valeur d'intensité de courant électrique correspondant à une phase de roulage distincte. Pour chaque point de fonctionnement, chaque valeur d'état de santé résistif intermédiaire $SOHR_i$ correspondant à une phase de roulage donnée i est par exemple calculée en divisant la valeur de résistance interne $DCR_i$ calculée lors de l'étape 16 pour cette phase de roulage par une valeur de résistance interne $DCR_{BOL}$ prédéterminée en début de vie de la batterie électrique. Pour chaque point de fonctionnement, chaque valeur d'état de santé résistif intermédiaire $SOHR_i$ s'exprime alors selon l'équation (1) suivante :

[Math]

$$SOHR_i = 100 \times \frac{DCR_i}{DCR_{BOL}} \quad (1)$$

Chaque valeur de résistance interne prédéterminée $DCR_{BOL}$ correspond à un point de fonctionnement donné (état de charge, température) et est issue d'une caractérisation typique effectuée au niveau de chaque cellule de la batterie électrique en début de vie de la batterie.

Chaque valeur d'état de santé résistif intermédiaire calculée $SOHR_i$ est alors stockée dans une des tables $17_{i1}$, $17_{i2}$, $17_{i3}$, conjointement avec la valeur de résistance interne correspondante $DCR_i$ ou à la place de cette valeur, et en lui associant la valeur de variation d'intensité correspondante $\Delta I_i$ mesurée lors de l'étape 14. Le système de gestion de la batterie calcule alors, au cours d'une seconde phase de l'étape 18 et pour chacun des points de fonctionnement de la plage de fonctionnement courante, en fonction des valeurs d'état de santé résistif intermédiaires calculées au cours de la première phase pour ce point de fonctionnement, une valeur d'état de santé résistif. Pour chaque point de fonctionnement, la valeur d'état de santé résistif SOHR est par exemple calculée en appliquant une moyenne sur l'ensemble des valeurs d'état de santé résistif intermédiaires $SOHR_i$ calculées lors de la première phase de calcul de l'étape 18, et en pondérant cette moyenne en fonction des valeurs de variation d'intensité $\Delta I_i$ associées à ces valeurs d'état de santé résistif intermédiaires $SOHR_i$. Pour chaque point de fonctionnement, la valeur d'état de santé résistif SOHR s'exprime alors selon l'équation (2) suivante :

[Math]

$$SOHR = \frac{\sum_i^N SOHR_i \times \Delta I_i}{\sum_i^N \Delta I_i} \quad (2)$$

N étant le nombre de valeurs d'état de santé résistif intermédiaires $SOHR_i$ calculées, autrement dit le nombre de phases de roulage prises en compte. Dans l'exemple de la figure 4, le nombre N est ainsi égal à trois. Les valeurs d'état de santé résistif SOHR sont ensuite stockées dans une seule table listant l'ensemble des points de fonctionnement.

De préférence, le procédé comporte une étape suivante 20 au cours de laquelle le système de gestion de la batterie calcule une valeur finale d'état de santé résistif de l'élément de stockage d'énergie électrique, en fonction des valeurs d'état de santé résistif SOHR calculées pour les différents points de fonctionnement lors de l'étape précédente 18. La valeur finale d'état de santé résistif est par exemple calculée comme la moyenne de l'ensemble des valeurs d'état de santé résistif SOHR calculées pour les différents points de fonctionnement.

Les étapes 10 à 20 ont été décrites précédemment en référence à des points de fonctionnement considérés selon le couple de variables : état de charge, température. En variante, ces mêmes étapes 10 à 20 peuvent être mises en œuvre d'une manière analogue en prenant en compte des points de fonctionnement considérés selon le triplet de variables : état de charge, température, intensité d'un courant de charge ou de décharge de la batterie. L'intensité du courant de charge ou de décharge de la batterie est par exemple une variable binaire dont la valeur indique le sens de polarisation du courant électrique circulant dans la batterie. Le courant peut être un courant de charge ou de décharge de la batterie pendant une phase de roulage du véhicule, un courant de charge circulant typiquement dans la batterie lors d'un mode de freinage régénératif du véhicule. Les tables stockées dans les moyens mémoire du système de gestion de la batterie définissent alors des points de fonctionnement selon trois dimensions correspondant à ces trois variables. Lors de l'étape de calcul 20, le système de gestion de la batterie calcule alors deux valeurs finales d'état de santé résistif de l'élément de stockage d'énergie électrique, une première valeur correspondant à un courant de charge de la batterie électrique, une seconde valeur correspondant à un courant de décharge de la batterie électrique.

Le procédé selon l'invention est simple à mettre en œuvre pendant des phases de roulage du véhicule, et est un procédé précis, robuste et réactif qui permet d'estimer précisément les limitations de la puissance que la batterie est à même de fournir à un état vieilli.

## Revendications

1. Procédé, mis en œuvre dans un système de gestion d'une batterie électrique d'un véhicule, d'estimation de l'état de santé résistif d'au moins un élément de stockage d'énergie électrique de ladite batterie électrique, te le procédé comportant les étapes suivantes :

   - une détermination (10) d'au moins une plage de fonctionnement (P1) pour laquelle la résistance interne dudit au moins un élément de stockage d'énergie électrique évolue de manière linéaire vis-à-vis d'un couple de variables constitué de l'état de charge de l'élément de stockage et de la température ;
   - une mesure (14), pour plusieurs points de fonctionnement de ladite au moins une plage de fonctionnement déterminée (P1) et pendant une durée prédéfinie, de la variation de l'intensité et de la tension d'un courant électrique généré par ledit au moins un élément de stockage d'énergie électrique pendant au moins une phase de roulage du véhicule ;
   - un calcul (16), en fonction des valeurs de variation d'intensité et de tension mesurées et pour chacun desdits points de fonctionnement, d'au moins une valeur de résistance interne dudit au moins un élément de stockage d'énergie électrique ; et
   - un calcul (18), pour chacun desdits points de fonctionnement, en fonction de la valeur de résistance interne calculée pour ledit point de fonctionnement, d'au moins une valeur d'état de santé résistif dudit au moins un élément de stockage d'énergie électrique.

2. Procédé selon la revendication 1, **caractérisé en ce que** l'étape (14) de mesure de la variation de l'intensité et de la tension d'un courant électrique est effectuée pendant un cycle dynamique de conduite du véhicule.

3. Procédé selon la revendication 1 ou 2, **caractérisé**

**en ce que**, lors de l'étape (10) de détermination d'au moins une plage de fonctionnement (P1) pour laquelle la résistance interne dudit au moins un élément de stockage d'énergie électrique évolue de manière linéaire, ladite au moins une plage de fonctionnement déterminée (P1) est une plage de fonctionnement pour laquelle la résistance interne dudit au moins un élément de stockage d'énergie électrique évolue de manière linéaire vis-à-vis de l'état de charge de l'élément de stockage, de la température et de l'intensité du courant électrique.

4. Procédé selon l'une quelconque des revendications 1 à 3, **caractérisé en ce que** le procédé comporte en outre une étape (12) de vérification, pour chacun desdits points de fonctionnement, d'au moins une condition remplie par l'intensité et/ou la tension du courant électrique généré par ledit au moins un élément de stockage d'énergie électrique, ladite étape de vérification (12) étant effectuée entre l'étape de détermination (10) et l'étape de mesure (14), la mesure de la variation de l'intensité et de la tension du courant électrique généré étant effectuée si ladite au moins une condition est vérifiée.

5. Procédé selon la revendication 4, **caractérisé en ce qu'**une première condition à vérifier consiste **en ce que** la valeur de l'intensité du courant électrique généré soit inférieure à une valeur seuil proche de zéro sur une première période prédéfinie (T1), et **en ce qu'**une deuxième condition à vérifier consiste **en ce que** l'intensité et la tension du courant électrique généré présentent chacune une valeur constante ou quasi constante sur une seconde période prédéfinie (Δt).

6. Procédé selon la revendication 5, **caractérisé en ce qu'**une troisième condition à vérifier consiste **en ce que**, à l'issue de la seconde période prédéfinie (Δt), la valeur de l'intensité du courant électrique généré soit inférieure à une valeur seuil d'intensité maximale, et/ou **en ce que** la variation de l'intensité du courant électrique entre le début et la fin de la seconde période prédéfinie (Δt) soit supérieure à une valeur de variation seuil.

7. Procédé selon l'une quelconque des revendications 1 à 6, **caractérisé en ce que** l'étape de mesure (14) est effectuée pour plusieurs phases de roulage du véhicule, et **en ce que** l'étape (18) de calcul d'au moins une valeur d'état de santé résistif comporte une première phase de calcul, pour chacun desdits points de fonctionnement, de plusieurs valeurs d'état de santé résistif intermédiaires, chaque valeur d'état de santé résistif intermédiaire étant associée, pour ledit point de fonctionnement, à une phase de roulage et à la valeur de variation d'intensité mesurée pour cette phase de roulage, et une seconde phase de calcul, pour chacun desdits points de fonctionnement, en fonction desdites valeurs d'état de santé résistif intermédiaires calculées pour ledit point de fonctionnement, d'une valeur d'état de santé résistif dudit au moins un élément de stockage d'énergie électrique.

8. Procédé selon la revendication 7, **caractérisé en ce que** la seconde phase de calcul de l'étape (18) de calcul d'une valeur d'état de santé résistif dudit au moins un élément de stockage d'énergie électrique consiste à appliquer une moyenne sur l'ensemble des valeurs d'état de santé résistif intermédiaires calculées lors de la première phase de calcul, et à pondérer cette moyenne en fonction des valeurs de variation d'intensité associées auxdites valeurs d'état de santé résistif intermédiaires.

9. Procédé selon la revendication 7 ou 8, **caractérisé en ce que** la première phase de calcul, pour chaque phase de roulage dans laquelle une mesure est effectuée, d'une valeur d'état de santé résistif intermédiaire, consiste à diviser la valeur de résistance interne calculée pour cette phase de roulage par une valeur de résistance interne prédéterminée en début de vie de la batterie électrique.

10. Procédé selon l'une quelconque des revendications 1 à 9, **caractérisé en ce que** ledit au moins un élément de stockage d'énergie électrique est choisi parmi le groupe consistant en : une cellule de stockage d'énergie électrique, un module de stockage d'énergie électrique constitué de plusieurs cellules de stockage reliées en série, et une batterie électrique constituée de plusieurs modules de stockage reliés en série.

**Patentansprüche**

1. Verfahren, implementiert in einem System zum Verwalten einer Elektrobatterie eines Fahrzeugs, zum Schätzen des Widerstandszustands von mindestens einem elektrischen Energiespeicherelement der Elektrobatterie, wobei das Verfahren die folgenden Schritte umfasst:

- eine Bestimmung (10) mindestens eines Betriebsbereichs (P1), für den sich der Innenwiderstand des mindestens einen elektrischen Energiespeicherelements linear in Bezug auf ein Variablenpaar bestehend aus Ladezustand des Speicherelements und Temperatur ändert;
- eine Messung (14) der Variation der Intensität und der Spannung eines elektrischen Stroms, der von dem mindestens einen elektrischen Energiespeicher erzeugt wird, für mehrere Betriebspunkte des mindestens einen bestimmten Betriebsbereichs (P1) und für eine vordefinierte Dauer Element während mindestens einer Fahrphase des Fahrzeugs;

- eine Berechnung (16), basierend auf den gemessenen Intensitäts- und Spannungsschwankungswerten und für jeden der Betriebspunkte, von mindestens einem Innenwiderstandswert des mindestens einen elektrischen Energiespeicherelements; Und

- eine Berechnung (18) für jeden der Betriebspunkte als Funktion des für den Betriebspunkt berechneten Innenwiderstandswerts von mindestens einem Widerstandswert des mindestens einen elektrischen Energiespeicherelements.

2. Verfahren nach Anspruch 1, **dadurch gekennzeichnet, dass** der Schritt (14) des Messens der Variation der Intensität und der Spannung eines elektrischen Stroms während eines dynamischen Fahrzyklus des Fahrzeugs durchgeführt wird.

3. Verfahren nach Anspruch 1 oder 2, **dadurch gekennzeichnet, dass** während des Schritts (10) des Bestimmens mindestens eines Betriebsbereichs (P1), für den sich der Innenwiderstand des mindestens einen elektrischen Energiespeicherelements linear entwickelt, dieser bestimmt wird Der Betriebsbereich (P1) ist ein Betriebsbereich, für den sich der Innenwiderstand des mindestens einen elektrischen Energiespeicherelements linear in Bezug auf den Ladezustand des Speicherelements entwickelt. von der Temperatur und der Intensität des elektrischen Stroms.

4. Verfahren nach einem der Ansprüche 1 bis 3, **dadurch gekennzeichnet, dass** das Verfahren außerdem einen Schritt (12) umfasst, bei dem für jeden der Betriebspunkte mindestens eine Bedingung überprüft wird , die von der Intensität und/oder der Spannung des elektrischen Stroms erfüllt wird erzeugt durch das mindestens eine elektrische Energiespeicherelement, wobei der Verifizierungsschritt (12) zwischen dem Bestimmungsschritt (10) und dem Messschritt (14) durchgeführt wird, die Messung der Intensitätsschwankung und der Spannung des erzeugten elektrischen Stroms durchgeführt wird, wenn die mindestens eine Bedingung erfüllt ist.

5. Verfahren nach Anspruch 4, **dadurch gekennzeichnet, dass** eine erste zu überprüfende Bedingung darin besteht, dass der Wert der Intensität des erzeugten elektrischen Stroms über einen ersten vordefinierten Zeitraum (T1) und in einem zweiten Zeitraum unter einem Schwellenwert nahe Null liegt Die zu überprüfende Bedingung besteht darin, dass die Intensität und die Spannung des erzeugten elektrischen Stroms jeweils über einen zweiten vordefinierten Zeitraum (∆t) einen konstanten oder nahezu konstanten Wert haben.

6. Verfahren nach Anspruch 5, **dadurch gekennzeichnet, dass** eine dritte zu überprüfende Bedingung darin besteht, dass am Ende des zweiten vordefinierten Zeitraums (∆t) der Wert der Intensität des erzeugten elektrischen Stroms unter einem Maximalwert liegt Intensitätsschwellenwert und/oder dadurch, dass die Variation der Intensität des elektrischen Stroms zwischen dem Beginn und dem Ende des zweiten vordefinierten Zeitraums (∆t) größer als ein Variationsschwellenwert ist.

7. Verfahren nach einem der Ansprüche 1 bis 6, **dadurch gekennzeichnet, dass** der Messschritt (14) für mehrere Rollphasen des Fahrzeugs durchgeführt wird und dass der Schritt (18) das Berechnen mindestens eines Widerstandszustandswerts umfasst eine erste Phase der Berechnung mehrerer Zwischenwerte für den Widerstandszustand des Betriebszustands, wobei jeder Zwischenwert des Widerstandszustands für den Betriebspunkt zugeordnet ist eine Antriebsphase und den für diese Antriebsphase gemessenen Intensitätsschwankungswert und eine zweite Berechnungsphase für jeden der Betriebspunkte als Funktion der für den Betriebspunkt berechneten Zwischenwerte des Widerstandszustands Zustandswert des mindestens einen elektrischen Energiespeicherelements.

8. Verfahren nach Anspruch 7, **dadurch gekennzeichnet, dass** die zweite Berechnungsphase des Schritts (18) der Berechnung eines Widerstandszustandswerts des mindestens einen elektrischen Energiespeicherelements darin besteht, einen Durchschnitt aller Zwischenwerte des Widerstandszustandszustands anzuwenden berechnet während der ersten Berechnungsphase, und um diesen Durchschnitt als Funktion der Intensitätsvariationswerte zu gewichten, die mit den genannten Zwischenwerten des Widerstandsgesundheitszustands verbunden sind.

9. Verfahren nach Anspruch 7 oder 8, **dadurch gekennzeichnet, dass** die erste Phase der Berechnung eines mittleren Widerstandswerts für den Gesundheitszustand für jede Fahrphase, in der eine Messung durchgeführt wird, darin besteht, den für diese Fahrphase berechneten Innenwiderstandswert zu dividieren durch einen vorgegebenen Innenwiderstandswert zu Beginn der Lebensdauer der elektrischen Batterie.

10. Verfahren nach einem der Ansprüche 1 bis 9, **dadurch gekennzeichnet, dass** das mindestens eine Speicherelement für elektrische Energie aus der Gruppe ausgewählt wird, die aus Folgendem besteht: einer Speicherzelle für elektrische Energie, einem Speichermodul für elektrische Energie, das aus mehreren miteinander verbundenen Speicherzellen besteht in Reihe und einer elektrischen Batterie, die aus mehreren in Reihe geschalteten Speichermodulen besteht.

## Claims

1. Method, implemented in a system for managing an electric battery of a vehicle, for estimating the resistive state of health of at least one electrical energy storage element of said electric battery, method comprising the following steps:

   - a determination (10) of at least one operating range (P1) for which the internal resistance of said at least one electrical energy storage element evolves linearly with respect to a pair of variables consisting of the state of charge of the storage element and the temperature;
   - a measurement (14), for several operating points of said at least one determined operating range (P1) and for a predefined duration, of the variation in the intensity and voltage of an electric current generated by said at least one electrical energy storage element during at least one driving phase of the vehicle;
   - a calculation (16), as a function of the measured intensity and voltage variation values and for each of said operating points, of at least one internal resistance value of said at least one electrical energy storage element; and
   - a calculation (18), for each of said operating points, as a function of the internal resistance value calculated for said operating point, of at least one resistive health state value of said at least one electrical energy storage element.

2. Method according to claim 1, **characterized in that** the step (14) of measuring the variation in the intensity and voltage of an electric current is carried out during a dynamic driving cycle of the vehicle.

3. Method according to claim 1 or 2, **characterized in that**, during the step (10) of determining at least one operating range (P1) for which the internal resistance of said at least one electrical energy storage element evolves linearly, said at least one determined operating range (P1) is an operating range for which the internal resistance of said at least one electrical energy storage element evolves linearly with respect to the state of charge of the storage element, the temperature and the intensity of the electric current.

4. Method according to any one of claims 1 to 3, **char-**

**acterized in that** the method further comprises a step (12) of verifying, for each of said operating points , at least one condition fulfilled by the intensity and/or the voltage of the electric current generated by said at least one electrical energy storage element, said verification step (12) being carried out between the determination step (10) and the measurement step (14), the measurement of the variation in the intensity and the voltage of the electric current generated being carried out if said at least one condition is verified.

5. Method according to claim 4, **characterized in that** a first condition to be verified consists **in that** the value of the intensity of the electric current generated is less than a threshold value close to zero over a first predefined period (T1), and **in that** a second condition to be verified consists **in that** the intensity and the voltage of the electric current generated each have a constant or quasi-constant value over a second predefined period ($\Delta t$).

6. Method according to claim 5, **characterized in that** a third condition to be verified consists **in that**, at the end of the second predefined period ($\Delta t$), the value of the intensity of the electric current generated is less than a maximum intensity threshold value, and/or **in that** the variation in the intensity of the electric current between the start and the end of the second predefined period ($\Delta t$) is greater than a threshold variation value.

7. Method according to any one of claims 1 to 6, **characterized in that** the measuring step (14) is carried out for several driving phases of the vehicle, and **in that** the step (18) of calculating at least one resistive health status value comprises a first calculation phase, for each of said operating points, of several intermediate resistive health status values, each intermediate resistive health status value being associated, for said operating point, with a driving phase and with the intensity variation value measured for this driving phase, and a second calculation phase, for each of said operating points, as a function of said intermediate resistive health status values calculated for said operating point, of a resistive health status value of said at least one electrical energy storage element.

8. Method according to claim 7, **characterized in that** the second calculation phase of the step (18) of calculating a resistive health status value of said at least one electrical energy storage element consists in applying an average to all of the intermediate resistive health status values calculated during the first calculation phase, and in weighting this average according to the intensity variation values associated with said intermediate resistive health status values.

9. Method according to claim 7 or 8, **characterized in that** the first calculation phase, for each driving phase in which a measurement is carried out, of an intermediate resistive health value, consists in dividing the internal resistance value calculated for this driving phase by an internal resistance value predetermined at the start of the life of the electric battery.

10. Method according to any one of claims 1 to 9, **characterized in that** said at least one electrical energy storage element is chosen from the group consisting of: an electrical energy storage cell, an electrical energy storage module consisting of several storage cells connected in series, and an electric battery consisting of several storage modules connected in series.

[Fig.1]

[Fig.2]

[Fig.3]

[Fig.4]

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2106129
- EP 3605127 A1
- FR 2965361 A1
- FR 2968769 A1